# EUROPEAN PATENT SPECIFICATION

(11) **EP 0 488 811 B1**
(45) Date of publication and mention of the grant of the patent: **25.10.1995**
(21) Application number: 91311154.8
(22) Date of filing: 29.11.1991
(51) Int. Cl.: G11B 5/035, G11B 5/53, G11B 20/10

(54) **Magnetic recording and reproducing apparatus**
Magnetisches Aufzeichnungs- und Wiedergabegerät
Appareil d'enregistrement et de reproduction magnétiques

(30) Priority: 30.11.1990 JP 339767/90
(43) Date of publication of application: 03.06.1992
(73) Proprietor: SONY CORPORATION, Tokyo 141 (JP)
(72) Inventor: Yoshida, Teruyuki, c/o Patents Division, Shinagawa-ku, Tokyo 141 (JP); Arai, Hideki, c/o Patents Division, Shinagawa-ku, Tokyo 141 (JP); Kanetsuka, Keiko, c/o Patents Division, Shinagawa-ku, Tokyo 141 (JP)
(74) Representative: Cotter, Ivan John

(56) References cited:
- EP-A- 0 332 520
- DE-A- 3 715 884
- PATENT ABSTRACTS OF JAPAN vol. 9, no. 31 (E-295) 9 February 1985

## Description

This invention relates to magnetic recording and reproducing apparatus, and more particularly to such an apparatus arranged for reproducing an information signal recorded on a magnetic tape by scanning the magnetic tape with a rotary head by a helical scan method.

It has been proposed to use a magnetic recording and reproducing apparatus as a data recording and reproducing apparatus for recording information data with a high density and reproducing the data by means of a digital video tape recorder employing the helical scan method.

In such a data recording and reproducing apparatus, the information data is coded by, for example, an 8-9 modulation method. A signal to be recorded, obtained as a consequence of such coding, is equalised by an equalising circuit and at the same time amplified by a recording amplifier circuit. The information data is then supplied to a rotary head mounted on a drum. The drum has wound thereon a magnetic tape to permit its running in an oblique direction. The rotary head thus scans the magnetic tape by the helical scan method.

In such a data recording and reproducing apparatus, the information data is typically recorded at a data rate of 88 Mbps (providing a maximum recording frequency of 44 MHz). A magnetising pattern which is reversed at the shortest interval of 0.9 micrometres is formed on a recording track of the magnetic tape.

In this data recording and reproducing apparatus, the speed of rotation of the rotary head and the running speed of the magnetic tape are controlled. The relative speed between the rotary head and the magnetic tape in the direction of the recording tracks is capable of being variably controlled to have a speed factor of 1/1, 1/2, 1/4, 1/8, 1/16 or 1/24. This results in the recorded information data having a data rate of 88, 44, 11, 5.50 or 3.76 Mbps, i.e., the recorded signal having a maximum recording frequency of 44, 22, 11, 5.50, 2.50 or 1.84 Mhz.

Thus, for example, in the case of information data recorded as a record signal having the maximum recording frequency of 44 Mhz and the data rate of 88 Mbps, the relative speed between the magnetic tape and the rotary head in the recording track direction can be variable-controlled to a speed factor of 2. The information data is thus readable as information data having the data rate of 44 Mbps, i.e., the maximum recording frequency of 22 MHz. Low speed reproduction at a speed factor of 1/2 is thus attainable.

As another example, in the case of information data recorded as a record signal having the data rate of 22 Mbps and the maximum recording frequency of 11 MHz, the relative speed can be variable-controlled to a speed factor of 1/1. The information data is readable as a piece of information data having the data rate of 88 Mbps, namely the maximum recording frequency of 44 MHz. As a result, high speed reproduction is thereby attainable at 4 times the speed.

As a matter of fact, in the case of the data recording and reproducing apparatus, variable-speed recording may, as described above, be effected at a speed of 1/1 to 1/24. Therefore, in the case of, for example, observation data which varies slowly, as in the case of astronomical observation, the data can be recorded at a data rate as slow as 3.67 Mbps and reproduced at a data rate as high as 88 Mbps. The data can thereby be efficiently analysed in a short time by using a computer system.

In contrast with this, in the case of measurement data or observation data which varies quickly, the data can be recorded at a data rate of as high as 88 Mbps and reproduced at a data rate as slow as 3.67 Mbps. The data can be surely analysed at a low speed. With this arrangement, the data recording apparatus is usable as a buffer for frequency conversion of information data containing a large amount of information.

In a reproducing system of the thus-constructed data recording and reproducing apparatus, an electromotive force e induced in the rotary head during a reproducing process exhibits a differential characteristicexpressed by the equation:$\text{e = -N.dø/dt}$
where N is the output of the rotary head. Supposing that the frequency characteristic of the magnetic tape is flat, the electromotive force e exhibits a rising characteristic of 6dB per octave.

The signal to noise (S/N) ratio of the reproduced output transmitted from a preamplifier increasingly deteriorates with reduced frequency on the assumption that this output is amplified by a preamplifier disposed within the drum and comprising a voltage type amplifier circuit having a given noise level.

Note that actually, as illustrated in Figure 1A of the accompanying drawings, in the reproducing system of such a data recording and reproducing apparatus 1, the information data recorded on a magnetic tape 3 is read by helical scanning of the magnetic tape 3 with a rotary head 2 having an electromotive force eH. A head output voltage V0 obtained as a consequence of this is amplified by an preamplifier 4, which is a voltage type amplifier circuit, and then transmitted as a reproduced output V1.

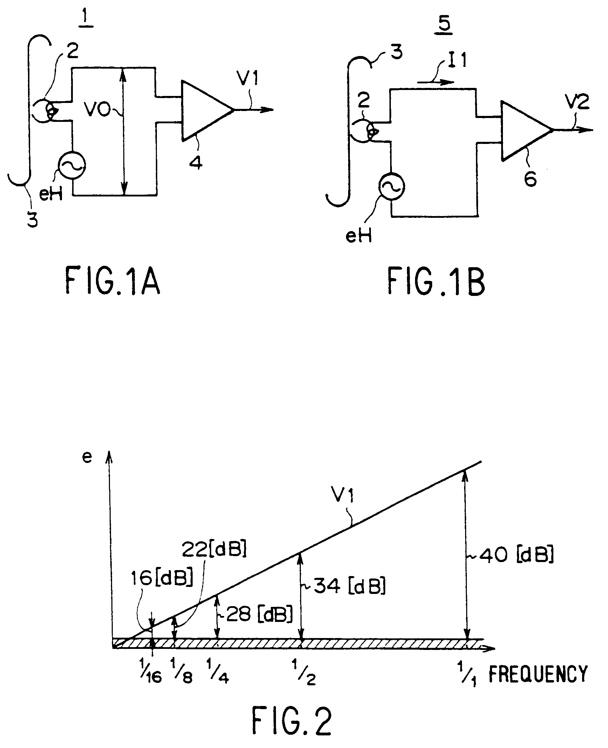

Where a preamplifier 4 which is a voltage type amplifier circuit is employed in the reproducing system of the data recording and reproducing apparatus for performing the variable-speed recording and reproducing processes in the manner discussed above, the C/N ratio of the reproduced output V1 transmitted by the preamplifier 4 assumes a characteristic as shown in Figure 2 of the accompanying drawings.

More specifically, it is presumed that when the C/N ratio for the shortest recording wavelength is set to 40 dB with a frequency band of a measurement object being 100 KHz at, e.g., the fastest relative speed, i.e. a 1/1 times speed factor, the C/N ratio deteriorates by 6 dB each time that the relative speed is slowed down in the speed factor sequence of 1/2, 1/4, 1/8, 1/16 and 1/24. Especially at the 1/16 and 1/24 speed factors, the reproduced output V1 cannot be obtained.

Therefore, in the data recording and reproducing apparatus 1 arranged to attain the variable-speed recording and reproducing processes at all the relative speeds, it is not feasible to use a preamplifier 4 which is a voltage type amplifier circuit.

For this reason, in the data recording and reproducing apparatus for performing the variable-speed recording and reproducing processes, use of a preamplifier which is a current type amplifier circuit with an input impedance approximately equal to zero can be regarded as advantageous in terms of C/N ratio.

Namely, as shown in Figure 1B of the accompanying drawings, in the reproducing system of a data recording and reproducing apparatus 5, information data recorded on the magnetic tape 3 is read by the rotary head 2 having the electromotive force eH. The resulting head output current I1 is amplified by a preamplifier 6 which is a current type amplifier circuit and then transmitted as a reproduced output V2.

In this case, the electromotive force eH of the rotary head 2 exhibits a rising characteristic of 6dB per octave. Correspondingly, the impedance Z of the rotary head 2 exhibits a rising characteristic of 6dB per octave as expressed by the equation:$\text{Z = WL}$

Consequently, if the input impedance of the preamplifier 6 is set to almost zero, the frequency characteristic of the input current becomes substantially flat. As a result, the C/N ratio does not vary substantially in dependence on the frequency.

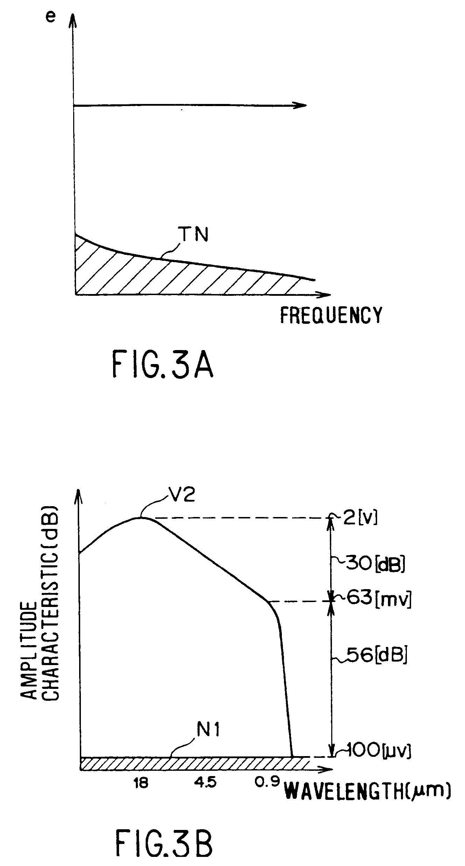

Incidentally, the amplification characteristic of the preamplifier 6 itself, which is a current type amplifier circuit, has a 6dB per octave rising characteristic. This, as a matter of fact, results in a noise characteristic TN as illustrated in Figure 3A of the accompanying drawings, due to input impedance noise and the like. A lower input impedance is advantageous in terms of noise caused by the preamplifier 6 itself. Hence, this is more advantageous in terms of the C/N ratio than the preamplifier 4 which is a voltage type amplifier circuit.

In the actual magnetic recording and reproducing operations, however, a magnetic conversion characteristic of the rotary head 2 exerts an influence. For this reason, as illustrated in Figure 3B of the accompanying drawings, the amplitude of a reproduced output V2 of the preamplifier 6 has a characteristic that increases in a long wavelength region.

Therefore, if the S/N ratio and the dynamic range are considered, taking account of a driver of a rotary transformer from next and subsequent stages of the preamplifier 6 within the drum, and when trying to secure an upper noise limit of 56 dB of the preamplifier 6 as well as a signal level of the next and subsequent stages with the noise N1 of the preamplifier 6 being set to 100 microvolts, the signal level required as the reproduced output V2 of the shortest wavelength (wavelength of 0.9 micrometres ) is approximately 63 millivolts.

When the wavelength obtains a head output of 18 micrometres from the rotary head 2 in such a state, the reproduced output V2 of the preamplifier 6 becomes approximately equal to 2 volts.

As a matter of fact, however, it is difficult to drive a signal as high as 2 volts in terms of the current capacity of the preamplifier 6 mounted within the drum and the electric power capacity of an integrated circuit. Therefore, when using a preamplifier 6 which is a current type amplifier circuit for reasons of S/N ratio, a problem arises in that the dynamic ranges of the amplifiers of the next and subsequent stages cannot be secured, particularly with respect to the low frequency component.

The present invention, which has been devised in the light of the foregoing points and is intended to solve or at least alleviate the above-mentioned problems en bloc, seeks to provide a magnetic recording and reproducing apparatus having a drum incorporating a reproducing amplification means having a good S/N ratio and a large dynamic range.

In a thus-constructed data recording and reproducing apparatus, the frequency band of a recording signal changes in response to the maximum recording frequencies of 44 to 1.84 MHz by virtue of a change of the data rate of recorded information data as described above.

Therefore, it is necessary to equalise the signal with an equalising characteristic corresponding to the frequency of the recorded signal, in order to form a certain magnetised pattern having compatibility with the data rate of the data recorded on the magnetic tape.

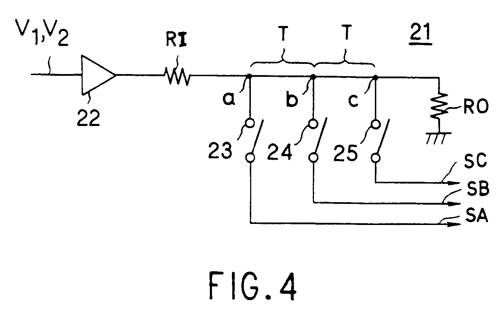

In view of this, a data recording and reproducing apparatus as described above has a plurality of equalising circuits having equalising characteristics corresponding to the frequencies of the recorded signal. The equalising circuits are selectively used by means of a branch circuit 21 shown in Figure 4 of the accompanying drawings.

In the branch circuit 21, a reproduced output is applied to a transmission line, via an input buffer 22 and an input resistance RI, the transmission line including connection nodes a to c to which respective input selection switches 23, 24 and 25, each comprising an analogue switch, are respectively connected. The transmission line is terminated by one end of a terminating resistance RO whose other end is connected to ground.

The input selection switches 23, 24 and 25 are controlled to be selectively turned on so that record signals SA, SB and SC sent out from the output terminals of the switches 23, 24 or 25 are inputted to equalisers (not shown) which have equalising characteristics that are different from each other.

Assuming that T is a delay time induced from every line connected among the series-connected connection nodes, the signals SA, SB and SC sent out from the input selection switches 23, 24 and 25 can be expressed, respectively, by the following equations:${\text{SA = Ee}}^{\text{jωt}}$${\text{SB = Ee}}^{\text{jω(t+T)}}$${\text{SC = Ee}}^{\text{jω(t+2T)}}$

Therefore, the problem arises that if there is mismatching between the line and the terminating resistance RO, the signals SA, SB and SC are, respectively, subjected to distortion as expressed by the following equations:${\text{SA = Ee}}^{\text{jωt}} {\text{+ kEe}}^{\text{jω(t+4T)}}$${\text{SB = Ee}}^{\text{jω(t+T)}} {\text{+ kEe}}^{\text{jω(t+2T)}}$${\text{SC = Ee}}^{\text{jω(t+2T)}}$

According to the invention there is provided a magnetic recording and reproducing apparatus comprising:
a rotary head mounted on a drum on which a magnetic tape can be wound so as to reproduce an information signal recorded on the magnetic tape by helical scanning of the tape;
a current amplification means for current amplifying a reproduced output obtained from the rotary head to produce a first reproduced signal, the current amplification means being disposed near the rotary head and inside of the drum;
a lower frequency band suppression means for suppressing a lower frequency band component of the first reproduced signal to produce a second reproduced signal;
a voltage amplification means for voltage amplifying the second reproduced signal to produce a third reproduced signal;
a rotary transformer rotatable together with the rotary head, the transformer having a primary winding for receiving the third reproduced signal and a secondary winding for emitting the third reproduced signal; and
a lower frequency band emphasis means for compensating said lower frequency band component suppression, effected by the lower frequency band suppression means, in the third reproduced signal emitted by the rotary transformer, the lower frequency band emphasis means being disposed outside of the drum.

A preferred embodiment of the invention described in detail below provides a magnetic recording and reproducing apparatus in which reproduced outputs are commonly inputted to a plurality of equalising circuits connected in cascade without (or at least with reduced) distortion of amplitude caused by reflection. In the preferred magnetic recording and reproducing apparatus, a plurality of equalising circuits (15A to 15F) is provided to effect predetermined signal processing. The equalising circuits (15A to 15F) are connected in cascade to have commonly inputted thereto a reproduced output (V12). The equalising circuits (15A to 15F) are so arranged that, in order of their proximity to a terminating resistance (R10), they process a reproduced output (V12) having a higher frequency.

The invention will now be further described, by way of illustrative and non-limiting example, with reference to the accompanying drawings, in which like parts are designated by like reference signs throughout, and in which:
Figures 1A and 1B are circuit diagrams of previously proposed data recording and reproducing apparatuses;
Figures 2, 3A and 3B are schematic diagrams used for explaining frequency characteristics of the previously proposed apparatuses;
Figure 4 is a circuit diagram of a previously proposed branch circuit;
Figures 5A and 5B are circuit diagrams of a data recording and reproducing apparatus according to an embodiment of the invention; and
Figures 6A to 6D are characteristic curves used for explaining the operation of the apparatus embodying the invention.

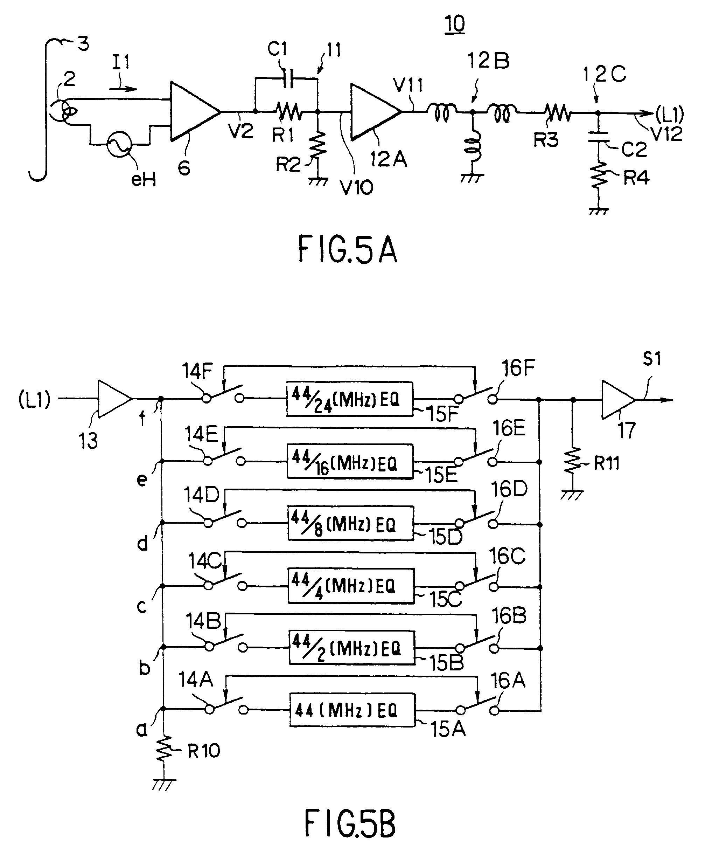

Figures 5A and 5B, in which elements corresponding to elements shown in Figures 1 to 4 are designated by the same symbols, depict a data recording and reproducing apparatus 10 embodying the invention. A rotary head 2 disposed in the interior of a rotary drum reads (reproduces) the content of a magnetic tape 3. A head output current I1 obtained as a result of this is inputted to a preamplifier 6 disposed near the head 2 and inside of the drum.

The preamplifier 6, which comprises a current type amplifier circuit, amplifies the head output current I1 and transmits the amplified current as a first reproduced output V2 to an emphasis circuit 11.

The emphasis circuit 11 is constructed as an RC differentiating circuit including resistances R1, R2 and a capacitor C1. The emphasis circuit 11 sunpresses a low frequency component of the first reproduced output V2 and inputs it as a second reproduced output V10 to a driver 12A which comprises a voltage type amplifier circuit.

The driver 12A amplifies the second reproduced output V10 inputted thereto and supplies it as a third reproduced output V11 to a primary winding of a rotary transformer 12B. The transformer 12B then transmits the output V11 to a de-emphasis circuit 12C disposed outside of the drum via a secondary winding thereof.

The de-emphasis circuit 12C is constructed as an RC integrating circuit including resistances R3, R4 and a capacitor C2. The deemphasis circuit 12C emphasises a low frequency component of the third reproduced output V11 and transmits it as a fourth reproduced output V12 to a subsequent reproducing signal processing circuit.

The de-emphasis circuit 12C has a characteristic such as to emphasise the low frequency component suppressed by the emphasis circuit 11, thereby compensating for the low frequency component suppression effected by the emphasis circuit 11.

As mentioned above, in the data recording and reproducing device 10 in accordance with this embodiment the preamplifier 6 amplifies the level of the head output current I1 sufficiently to obtain the first reproduced output V2. A low frequency component of the reproduced output which may cause a problem in terms of noise level in the driver 12A is suppressed sufficiently and then inputted to the driver 12A. Thus, the preamplifier 6 within the drum is capable of securing an adequate S/N ratio and dynamic range.

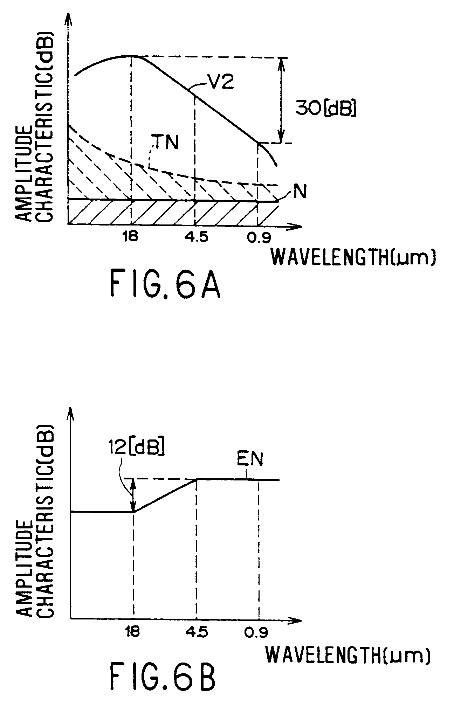

The first reproduced output V2 obtained from the preamplifier 6, the magnetic conversion characteristic of the magnetic tape 3 and of the rotary head 2, noise TN corresponding to the preamplifier 6 and noise N1 of the driver 12A have, as explained above, frequency characteristics as shown in Figure 6A.

The emphasis circuit 11, on the other hand is, as shown in Figure 6B, set to have a suppression characteristic EN such as to depress the low frequency component in which the recording wavelength is 18 micrometres or more by 12 dB.

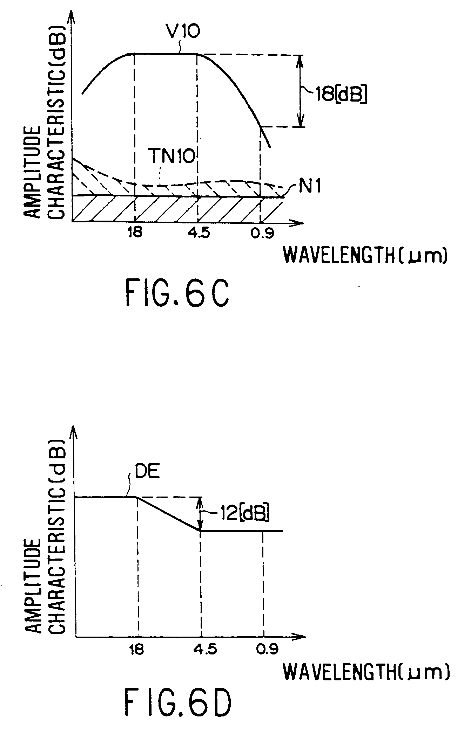

Thus, the second reproduced output V10 inputted to the driver 12A, as well as the noise TN contained in the second reproduced output V10, as shown in Figure 6C, exhibit frequency characteristics such that the low frequency component of the first reproduced output V2 and the low frequency component of the noise TN associated with the preamplifier 6 are suppressed. The noise level of the low frequency component which causes the problem in the driver 12A is thereby sufficiently suppressed.

As a result of this, it is possible to obtain a third reproduced output V11 in which the dynamic range is secured by effecting sufficient amplification with a good S/N ratio in regard to the second reproduced output V10 in the driver 12A. This reproduced output is transmitted via the rotary transformer 12B to the de-emphasis circuit 12C.

The de-emphasis circuit 12C is, as illustrated in Figure 6D, set to have an emphasis characteristic DE such as to raise the low frequency component having a recording wavelength of 18 micrometres or more by 12 dB with respect to the suppressed characteristic EN of the emphasis circuit 11. A power source voltage and electric power after the rotary transformer 12B are thereby sufficiently secured. In this state, the frequency characteristic of the third reproduced output V11 reverts to the frequency characteristic of the original first reproduced output V2.

In addition, the fourth reproduced input V12 is, as shown in Figure 5B, supplied to equalising circuits 15A to 15F via an input buffer circuit 13. The reproduced input V12 is supplied via the input buffer circuit 13 to one end of each of input selection switches 14A, 14B, 14C, 14E and 14F which comprise analogue switches and are connected to respective ones of a series of connection nodes a to f. The one node a forming a terminated end of the series of nodes is connected to ground via an input side terminating resistance R10.

One of the input selection switches 14A to 14F is selectively on-controlled so that signals outputted from the other ends of the switches 14A to 14F are inputted to respective corresponding equalising circuits 15A, 15B, 15C, 15D, 15E and 15F.

If a mismatch is for example induced between the connecting nodes and the terminating resistance R10, the nearer a node is to the terminating resistance R10 the smaller is the influence on amplitude distortion by reflection, and the further the node is from the terminating resistance the larger is the influence, as is clearly represented by Equations (6) to (8) above.

Therefore, in this embodiment, the equalising circuits 15A to 15F sequentially connected to the series of connecting nodes are respectively selected so as to have equalising characteristics corresponding to maximum recording frequencies of 44 MHz, 44/22 (=22) MHz, 44/4 (=11) MHz, 44/8 (=5.50) mHz, 44/16 (=2.25) MHz and 44/24 (=1.84) MHz in their order of proximity (nearness) to the terminating resistance R10. In this way, the influence of reflection on amplitude distortion can be reduced.

In practice, the equalising circuits 15A to 15F can be arranged on a printed circuit board with the circuit patterns in the order of proximity described above.

As a result, the components of the signal are respectively equalised in the equalising circuits having the maximum recording frequencies of 44 to 1.84 MHz and then supplied to an output buffer 17 via output selection switches 16A to 16F each comprising an analogue switch and one end of an outside terminating resistance R11 which is connected to ground at its other end.

Interlocking with the input selection switches 14A to 14F, one of the output selection switches 16A to 16F is on-controlled so that a record signal S1 outputted from the output buffer 17 is equalised with an equalising characteristic corresponding to the maximum recording frequency of 44 to 1.84 MHz.

By virtue of the construction as described above, on inputting the reproduced output V12 through the equalising circuits 15A to 15F connected in cascade, equalising circuits having equalising characteristics for such maximum recording frequencies that are of higher frequency in order of proximity to the terminating resistance R10 are connected. It is thus possible to realise a data recording and reproducing apparatus 10 in which induction of amplitude distortion by reflection is avoidable.

Based on the construction described above, the preamplifier 6 sufficiently amplifies the level of the head output current I1 so as thereby to obtain the first reproduced output V2. The low frequency component of the output V2, which may cause the above-mentioned problem in terms of the noise level in the driver 12A, is sufficiently suppressed and then inputted to the driver 12A. The power source voltage and electric power after the rotary transformer 12B can be sufficiently secured. In this state, the frequency characteristic reverts to its original characteristic. It is thus possible to attain a data recording and reproducing apparatus 10 in which the preamplifier 6 in the drum is capable of securing a sufficient S/N ratio and dynamic range.

Note that the emphasis circuit 11 and the de-emphasis circuit 12C in the above-discussed embodiment exhibit characteristics such as to depress and raise the low frequency component having the recording wavelength of 18 micrometres or more. However, the low frequency component is not limited to the recording wavelength of 18 micrometres or more, but may be set to a variety of values based on a consideration of noise characteristics. In short, the same effects as those described above are attainable by setting a characteristic such as to raise the low frequency component in the de-emphasis circuit provided outwardly of the drum by a value depressed in the emphasis circuit provided inwardly of the drum.

In the embodiment described above, the invention is applied to a data recording and reproducing apparatus. But is not limited to this application. The invention is suitable more widely for application to any magnetic recording and reproducing apparatus such as, for example, a digital video tape recorder and a digital audio tape recorder for effecting recording and reproducing processes by helically scanning a magnetic tape with a rotary head mounted on a drum.

Further, based on the construction given above, on inputting the reproduced output V12 through the equalising circuits 15A to 15F connected in cascade, the equalising circuits 15A to 15F having the equalising characteristics such that the maximum recording frequencies that are higher in order of proximity to the terminating resistance R10 are connected. It is thus possible to realise a data recording and reproducing apparatus 10 in which the induction of amplitude distortion by reflection is avoidable.

In the embodiment described above, the switches 14A to 14F and 16A to 16F, interlocked with each other, are disposed at input stages and output stages of the equalising circuits 15A to 15F, respectively. However, this is not an essential feature of the invention. The invention may be embodied in such a manner that switches disposed at the input stage or the output stage only may be on-controlled.

Further, whereas in the embodiment described above the invention is applied to a reproducing signal processing circuit of the data recording and reproducing apparatus, the present invention is also applicable to an equalising circuit of a recording signal processing circuit.

Furthermore, although in the embodiment described above the invention is applied to an equalising circuit of a data recording and reproducing apparatus, the invention is more widely applicable to a frequency signal processing apparatus in which a frequency signal is commonly inputted to signal processing circuits which are cascade connected with each other and which comprise for example, a plurality of low pass filters, or a plurality of tuner means, or the like.

## Claims

1. A magnetic recording and reproducing apparatus comprising:
a rotary head (2) mounted on a drum on which a magnetic tape (3) can be wound so as to reproduce an information signal recorded on the magnetic tape (3) by helical scanning of the tape;
a current amplification means (6) for current amplifying a reproduced output obtained from the rotary head (2) to produce a first reproduced signal (V2), the current amplification means (6) being disposed near the rotary head (2) and inside of the drum;
a lower frequency band suppression means (11) for suppressing a lower frequency band component of the first reproduced signal (V2) to produce a second reproduced signal (V10);
a voltage amplification means (12A) for voltage amplifying the second reproduced signal (V10) to produce a third reproduced signal (V11);
a rotary transformer (12B) rotatable together with the rotary head (2), the transformer having a primary winding for receiving the third reproduced signal (V11) and a secondary winding for emitting the third reproduced signal (V11); and
a lower frequency band emphasis means (12C) for compensating said lower frequency band component suppression, effected by the lower frequency band suppression means, in the third reproduced signal (V11) emitted by the rotary transformer (12B), the lower frequency band emphasis means (12B) being disposed outside of the drum.

2. Apparatus according to claim 1, which is so operative that, if an information signal of any of a plurality of frequency ranges is recorded with the same recording wavelength on the magnetic tape (3), the recorded information signal is reproduced with a predetermined frequency range.

3. Apparatus according to claim 2, comprising:
a plural number of equalising means (15A to 15F) for equalising an output from the lower band emphasis means (12C), said plural number corresponding to said plurality of frequency ranges, each equalising means having an input end for receiving an output from the lower band emphasis means (12C);
a terminating resistance (R10) connected to said input ends of the equalising means (15A to 15F) via a transmission line; and
a plurality of switch means (14,16) for selectively connecting the plurality of equalising means (15A to 15F) to equalise an output from the lower band emphasis means (12C) which is connected to the transmission line;
the plurality of equalising means (15A to 15F) being so arranged that the respective equalising means are connected to the transmission line in an order such that, the nearer the equalising means is to the terminating resistance (R10), the higher is a respective one of said frequency ranges which is associated with the respective equalising means.

4. Apparatus according to claim 1, which is capable of reproducing a said information signal that is a digital type information signal.

## Patentansprüche

1. Magnetisches Aufzeichnungs- und Wiedergabegerät, mit:
einem Drehkopf (2), der auf einer Trommel befestigt ist, um welche ein Magnetband (3) geschlungen werden kann, um ein Informationssignal wiederzugeben, das auf dem Magnetband (3) aufgezeichnet ist, durch Schrägabtastung des Bandes;
einer Stromverstärkungseinrichtung (6) zur Stromverstärkung eines Wiedergabeausgangssignals, das vom Drehkopf (2) erhalten wird, um ein erstes Wiedergabesignal (V2) zu erzeugen, wobei die Stromverstärkungseinrichtung (6) in der Nähe des Drehkopfs (2) und innerhalb der Trommel angeordnet ist;
einer Niederfrequenzbandunterdrückungsseinrichtung zum Unterdrücken einer Niederfrequenzbandkomponente des ersten Wiedergabesignals (V2), um ein zweites Wiedergabesignal (V10) zu erzeugen;
einer Spannungsverstärkungseinrichtung (12A) zur Spannungsverstärkung des zweiten Wiedergabesignals (V10), um ein drittes Wiedergabesignal (V11) zu erzeugen;
einem Drehumformer (12B), der zusammen mit dem Drehkopf (2) drehbar ist, wobei der Umformer eine Primärwicklung zum Empfang des dritten Wiedergabesignals (V11) und eine Sekundärwicklung zur Abgabe des dritten Wiedergabesignals (V11) aufweist; und
einer Niederfrequenzbandanhebungseinrichtung (12C), um die Niederfrequenzbandkomponentenunterdrückung zu kompensieren, die durch die Niederfrequenzbandunterdrückungseinrichtung im dritten Wiedergabesignal (V11) bewirkt wurde, das durch den Drehumformer (12B) abgegeben wird, wobei die Niederfrequenzbandanhebungseinrichtung (12C) außerhalb der Trommel angeordnet ist.

2. Gerät nach Anspruch 1, das derart arbeitet, daß, wenn ein Informationssignal eines von mehreren Frequenzbereichen mit der gleichen Aufzeichnungswellenlänge auf dem Magnetband (3) aufgezeichnet ist, das Aufzeichnungsinformationssignal mit einem vorgegebenen Frequenzbereich wiedergegeben wird.

3. Gerät nach Anspruch 2, mit:
mehreren Entzerrungseinrichtungen (15A bis 15F) zur Entzerrung eines Ausgangssignals der Niederbandanhebungseinrichtung (12C), wobei diese den Frequenzbereichen entsprechen, wobei jede Entzerrungseinrichtung einen Eingang zum Empfang eines Ausgangssignals von der Niederbandanhebungseinrichtung (12C) aufweist;
einem Abschlußwiderstand (R10), der mit den Eingängen der Entzerrungseinrichtung (15A bis 15F) über eine Übertragungsleitung verbunden ist; und
mehreren Schalteinrichtungen (14, 16), um wahlweise die Entzerrungseinrichtungen (15A bis 15F) zu schalten, um ein Ausgangssignal von der Niederbandanhebungseinrichtung (12C) zu entzerren, die mit der Übertragungsleitung verbunden ist;
wobei die Entzerrungseinrichtungen (15A bis 15F) derart angeordnet sind, daß die jeweilige Entzerrungseinrichtung mit der Übertragungsleitung in einer Reihenfolge derart verbunden ist, daß je näher die Entzerrungseinrichtung am Abschlußwiderstand (R10) ist, der mit der entsprechenden Entzerrungseinrichtung in Verbindung steht, desto höher ein entsprechender der Frequenzbereiche ist.

4. Gerät nach Anspruch 1, das in der Lage ist, ein Informationssignal wiederzugeben, das aus einem digitalen Informationssignal besteht.

## Revendications

1. Appareil d'enregistrement et reproduction magnétiques, comprenant:
- une tête tournante (2) montée dans un tambour sur lequel une bande magnétique (3) peut être enroulée, de manière à reproduire un signal d'informations enregistré sur la bande magnétique (3) par balayage hélicoïdal de la bande;
- des moyens d'amplification de courant (6) pour amplifier en courant un signal de sortie reproduit obtenu à partir de la tête tournante (2) pour produire un premier signal reproduit (V2), les moyens amplificateurs de courant (6) étant disposés près de la tête tournante (2), à l'intérieur du tambour;
- des moyens de suppression de bande inférieure de fréquences (11) pour supprimer une composante à bande inférieure de fréquences du premier signal reproduit V2 pour produire un deuxième signal reproduit (V10);
- des moyens amplificateurs de tension (12A) pour amplifier en tension le deuxième signal reproduit (V10) pour produire un troisième signal reproduit (V11);
- un transformateur tournant (12B) tournant avec la tête tournante (2), le transformateur ayant un enroulement primaire pour recevoir le troisième signal reproduit (V11) et un enroulement secondaire pour émettre le troisième signal reproduit (V11); et
- des moyens d'accentuation de bande inférieure de fréquences (12C) pour compenser ladite suppression de composante à bande inférieure de fréquences effectuée par les moyens de suppression de bande inférieure de fréquences, dans le troisième signal reproduit (V11) émis par le transformateur tournant (12B), les moyens d'accentuation de bande inférieure de fréquences (12B) étant disposés à l'extérieur du tambour.

2. Appareil selon la revendication 1, qu fonctionne de telle manière que si un signal d'informations d'une gamme quelconque d'une pluralité de gammes de fréquences est enregistré avec la même longueur d'onde d'enregistrement sur la bande magnétique (3), le signal d'informations enregistré est reproduit avec une gamme de fréquences prédéterminée.

3. Appareil selon la revendication 2, comprenant:
- un certain nombre de moyens égaliseurs (15A à 15F) pour égaliser un signal de sortie issu des moyens d'accentuation de bande inférieure (12C), ledit certain nombre correspondant à ladite pluralité de gammes de fréquences, chaque moyen égaliseur ayant une extrémité d'entrée pour recevoir un signal de sortie issu des moyens d'accentuation de bande inférieure (12C);
- une résistance de bouclage (R10) connectée auxdites extrémités d'entrée des moyens égaliseurs (15A à 154F) par l'intermédiaire d'une ligne de transmission; et
- une pluralité de moyens formant des commutateurs (14, 16) pour connecter sélectivement la pluralité de moyens égaliseurs (15A à 15F) pour égaliser un signal de sortie des moyens d'accentuation de bande inférieure (12C) qui sont connectés à la ligne de transmission,
la pluralité de moyens égaliseurs (15A à 15F) étant égencée de telle manière que les moyens égaliseurs respectifs soeint connectés à la ligne de transmission dans un ordre tel que plus le moyen égaliseur est proche de la résistance de bouclage (R10), plus haute est une gamme respective parmi lesdites gammes de fréquences, qui est associée au moyen égaliseur respectif.

4. Appareil selon la revendication 1, qui est apte à reproduire un dit signal d'informations qui est un signal d'informations du type numérique.
